(19) Europäisches Patentamt / European Patent Office / Office européen des brevets

(11) **EP 2 850 442 B1**

(12) **FASCICULE DE BREVET EUROPEEN**

(45) Date de publication et mention de la délivrance du brevet:
**25.08.2021 Bulletin 2021/34**

(21) Numéro de dépôt: **13727248.0**

(22) Date de dépôt: **03.05.2013**

(51) Int Cl.:
**G01R 31/34** *(2020.01)*　　**H02P 29/02** *(2016.01)*

(86) Numéro de dépôt international:
**PCT/FR2013/050989**

(87) Numéro de publication internationale:
**WO 2013/171403 (21.11.2013 Gazette 2013/47)**

(54) **PROCÉDÉ DE DÉTERMINATION D'AU MOINS UN ÉTAT D'UN CIRCUIT ÉLECTRIQUE**

VERFAHREN ZUR BESTIMMUNG VON WENIGSTENS EINES ZUSTANDES EINER ELEKTRISCHEN SCHALTUNG

METHOD FOR DETERMINING AT LEAST ONE STATE OF AN ELECTRIC CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.05.2012 FR 1254546**

(43) Date de publication de la demande:
**25.03.2015 Bulletin 2015/13**

(73) Titulaire: **Valeo Systèmes de Contrôle Moteur 95800 Cergy Saint-Christophe (FR)**

(72) Inventeur: **BRUYERE, Antoine F-78700 Evequemont (FR)**

(74) Mandataire: **Argyma 14 Boulevard de Strasbourg 31000 Toulouse (FR)**

(56) Documents cités:
**US-A- 5 568 034**

• **Hussein Dogan ET AL: "Performance Analysis and Comparison of Three IPMSM with High Homopolar Inductance for Electric Vehicle Applications", EPE 2011, 14 septembre 2011 (2011-09-14), pages 1-10, XP055054467, Birmingham ISBN: 978-9-07-581515-3 Extrait de l'Internet: URL:http://hal.inria.fr/docs/00/62/36/11/P DF/0751-epe2011-full-20321821.pdf [extrait le 2013-02-25]**
• **ERTUGRUL N ET AL: "Fault tolerant motor drive system with redundancy for critical applications", POWER ELECTRONICS SPECIALISTS CONFERENCE; [ANNUAL POWER ELECTRONICS SPECIALISTS CONFERENCE],, vol. 3, 23 juin 2002 (2002-06-23), pages 1457-1462, XP010595953, ISBN: 978-0-7803-7262-7**
• **ABOLHASSANI M T ET AL: "Fault tolerant permanent magnet motor drives for electric vehicles", ELECTRIC MACHINES AND DRIVES CONFERENCE, 2009. IEMDC '09. IEEE INTERNATIONAL, IEEE, PISCATAWAY, NJ, USA, 3 mai 2009 (2009-05-03), pages 1146-1152, XP031475916, ISBN: 978-1-4244-4251-5**
• **None**

EP 2 850 442 B1

**Description**

La présente invention concerne la détermination d'au moins un état d'un circuit électrique comportant au moins un enroulement électrique de stator de machine électrique tournante polyphasée. Cette machine électrique tournante polyphasée est par exemple utilisée pour propulser un véhicule électrique ou hybride.

Le document US5568034 A décrit un entraînement par moteur à induction à vitesse variable tolérant aux pannes. Le courant homopolaire est ajouté aux signaux de commande de courant et cette somme passe par les phases qui sont opérationnelles.

Il est souhaitable, notamment avant de procéder au démarrage de la machine électrique tournante, de s'assurer que cette dernière est en état de fonctionner.

La machine électrique peut être alimentée électriquement par une source d'énergie électrique à travers un système de commutation et il peut également être souhaitable de s'assurer que le système de commutation, par lequel le fonctionnement du moteur pourra être contrôlé, est opérationnel.

En outre, un ou plusieurs organes de mesure de grandeur liée au passage de courant électrique dans l'enroulement électrique de stator et faisant partie du circuit électrique peuvent être utilisés pour le contrôle de la machine électrique tournante et il peut s'avérer souhaitable de s'assurer que ce ou ces organes de mesure sont bien opérationnels.

L'invention a pour but de proposer un procédé permettant de s'assurer que tout ou partie des éléments mentionnés ci-dessus est opérationnel.

Selon l'un de ses aspects, l'invention y parvient à l'aide d'un procédé de détermination d'au moins un état d'un circuit électrique, le circuit électrique comportant au moins :

- un enroulement électrique de stator de machine électrique polyphasée, notamment tournante, ledit enroulement comprenant une pluralité de phases électriques, lesdites phases n'étant pas électriquement couplées entre elles,
- un système de commutation à travers lequel l'enroulement électrique de stator est alimenté par une source d'énergie électrique,

procédé dans lequel :

- on commande le système de commutation de manière à ce que l'enroulement électrique de stator soit parcouru par le courant homopolaire, et
- selon que l'enroulement électrique de stator est effectivement ou non parcouru par le courant homopolaire, on détermine ledit état du circuit électrique.

Le procédé ci-dessus consiste à déterminer la réponse de l'enroulement électrique de stator lorsque l'on commande le système de commutation de manière à ce que la sortie de ce dernier injecte du courant homopolaire dans l'enroulement électrique de stator.

La machine électrique peut être une machine tournante configurée pour que la force électromotrice induite dans chaque phase du stator soit sinusoïdale ou ne comporte pas d'harmonique de rang 3 ou de rang multiple de 3 lorsque l'enroulement électrique de stator est parcouru par le courant homopolaire. Dans le cas d'une telle machine électrique tournante dont l'enroulement électrique de stator est alimenté par un courant homopolaire, aucun couple n'est appliqué au rotor En effet, le courant dans chaque phase crée alors chacun un champ constant, voire pulsant, mais la combinaison de ces champs ne crée pas de champ global dans l'entrefer de la machine tournant à la vitesse de synchronisme, de sorte qu'aucun couple n'est exercé sur le rotor de la machine électrique tournante.

La détermination de l'état du circuit électrique se fait ainsi en injectant un courant qui ne génère pas de couple sur le rotor, évitant des mouvements non souhaités de la machine.

En variante, le procédé peut être appliqué à des machines électriques tournantes pour lesquelles un faible couple est appliqué au rotor lorsque le stator est alimenté en courant homopolaire. Le courant homopolaire ne génère alors qu'un faible couple au rotor qui reste acceptable.

Chaque phase électrique peut comprendre une ou plusieurs bobines, montées en série ou en parallèle.

L'enroulement électrique de stator est par exemple équilibré et/ou régulièrement construit. Par « équilibré », il faut comprendre que chaque phase électrique est identique, aux tolérances de fabrication près. Par « phases identiques », on désigne des phases électriques comprenant chacune le même nombre de bobines, ces dernières ayant le même nombre de spires et étant réalisées en un même matériau et avec du fil de même section transversale.

Par « régulièrement construit », il faut comprendre que chaque phase électrique de l'enroulement électrique de stator est disposée dans la carcasse du stator à l'identique des autres phases électriques avec un décalage angulaire régulier entre ces phases électriques.

Lorsque l'enroulement électrique de stator comprend N phases électriques, le courant homopolaire $i_{M0}$ est défini comme suit :

$$i_{M0} = \frac{\sum_{j=1}^{N} i_j}{N}$$

Selon le procédé ci-dessus, le système de commutation est commandé de manière à ce que chaque phase électrique soit parcourue par un courant propre non nul de valeur $i_{M0}$. Chaque phase électrique peut être uniquement parcourue par le courant homopolaire $i_{M0}$.

Le système de commutation peut comprendre une pluralité de cellules de commutation et lorsque ces cellules de commutation sont commandées selon une même période de commutation, les phases électriques sont chacune parcourues par un courant électrique propre de même valeur moyenne, sur ladite période de commutation.

Les phases électriques ne sont pas couplées entre elles, c'est-à-dire qu'aucune phase électrique de l'enroulement électrique de stator n'a de borne reliée directement à une borne d'une autre phase de l'enroulement électrique de stator. « Les phases ne sont pas électriquement couplées entre elles » est synonyme de « les phases électriques sont indépendantes ».

Les phases électriques du circuit électrique de stator peuvent n'être ni couplées en étoile, ni couplées en polygonal, c'est-à-dire en triangle lorsque l'enroulement électrique de stator est triphasé.

Dans le cas d'un enroulement électrique de stator à trois phases u, v et w, chaque phase étant respectivement parcourue par un courant électrique propre $i_u$, $i_v$ et $i_w$, le système de commutation est commandé pour que $i_u$, $i_v$ et $i_w$ soient tous égaux à $i_{M0}$, à l'exception des instants lors desquels une commutation se produit dans le système de commutation.

Le circuit électrique peut comprendre au moins un organe de mesure de grandeur électrique liée au passage de courant électrique dans l'enroulement électrique de stator, ladite grandeur permettant de déterminer si l'enroulement électrique de stator est effectivement ou non parcouru par du courant homopolaire. Cet organe de mesure comprend par exemple autant de voltmètres qu'il y a de phases électriques du stator ou autant d'ampèremètres qu'il y a de phases électriques.

Grâce à cet organe de mesure de grandeur électrique, on détermine ainsi la valeur du courant dans chaque phase électrique ou la valeur de la tension induite aux bornes de chaque phase. Lorsque l'on obtient une même valeur de courant ou de tension pour chaque phase électrique, cela signifie que l'enroulement électrique de stator est effectivement parcouru par du courant homopolaire. Une marge de tolérance pour le courant, respectivement la tension, peut exister lorsque l'on compare le courant, respectivement la tension, dans l'enroulement électrique de stator. On peut considérer que l'on obtient une même valeur de courant, respectivement de tension, si, par exemple, la variation entre la plus grande et la plus petite valeur de courant, respectivement de tension, est inférieure à 10% de la valeur moyenne desdites valeur de courant, respectivement de tension que l'on mesure dans l'enroulement électrique de stator.

On en déduit alors que le système de commutation est opérationnel puisqu'il fonctionne conformément à la commande qui lui a été appliquée.. On peut par exemple conclure que les cellules de commutation du système de commutation sont opérationnelles. Celles-ci comprennent par exemple un interrupteur commandable et une diode montée en anti-parallèle et l'on conclut que ces interrupteurs commandables et ces diodes sont opérationnels. Chaque cellule de commutation peut être réversible.

Le système de commutation peut comprendre une unité de contrôle mettant en œuvre un traitement analogique ou numérique de données, par exemple à l'aide de microcontrôleur(s) et/ou de circuit(s) logique(s) programmable(s) (FPGA en anglais) et le fait que l'enroulement électrique de stator soit parcouru par du courant homopolaire permet de déterminer que cette unité de contrôle est opérationnelle.

En variante ou en combinaison de ce qui précède, un organe de mesure de température peut être associé à l'enroulement électrique de stator. L'organe de mesure de température comprend par exemple autant de capteurs qu'il y a de phases et la vérification que l'enroulement électrique de stator est parcouru par du courant homopolaire peut être effectuée à l'aide des informations fournies par cet organe de mesure de température. On détermine ainsi si les cellules de commutation et/ou l'unité de commande sont opérationnelles en comparant d'une phase électrique à l'autre la valeur de température fournie par l'organe de mesure de température. Une marge de tolérance peut être appliquée lorsque l'on compare ces valeurs de température. On peut par exemple conclure que l'enroulement électrique de stator est parcouru par du courant homopolaire lorsque l'écart maximal entre les valeurs de température est inférieur à 15 % de la valeur moyenne desdites valeurs de température que l'on mesure dans l'enroulement électrique de stator. Chaque capteur de température peut être implanté au niveau des têtes de bobines..

L'organe de mesure de température ci-dessus et/ou l'organe de mesure de grandeur électrique ci-dessus permettant de déterminer si l'enroulement électrique de stator est effectivement parcouru par du courant homopolaire peuvent avoir été préalablement étalonnés. Au sens de la présente invention, « préalablement étalonné » signifie que la marge d'erreur de cet organe de mesure est connue comme étant inférieure à par exemple 5 %.

Le circuit électrique peut comprendre au moins deux organes de mesure mesurant chacun une grandeur liée au passage de courant électrique dans l'enroulement électrique de stator et seul l'un de ces organes de mesure peut avoir été préalablement étalonné. Lorsque les informations fournies par cet organe de mesure confirment que l'enroulement électrique de stator est parcouru par du courant homopolaire, la comparaison entre ces informations et celles fournies par l'autre organe de mesure permet de déterminer si ce dernier est opérationnel ou non. Un organe de mesure peut être opérationnel au sens de la présente invention si sa marge d'erreur est inférieure par exemple à 10 %.

L'organe de mesure préalablement étalonné est par exemple l'organe de mesure de température ci-dessus et l'organe de mesure dont on cherche à déterminer s'il est opérationnel est par exemple un organe de mesure de courant ou un organe de mesure de tension.

En variante, un organe de mesure de courant et un organe de mesure de tension peuvent être prévus en plus de l'organe de mesure de température préalablement étalonné et l'on peut simultanément déterminer si ces organes de mesure de tension et de courant sont opérationnels en fonction des informations fournies par l'organe de mesure de température.

En variante encore, l'organe de mesure de courant ou l'organe de mesure de tension a été préalablement étalonné, ce qui n'est pas le cas de l'organe de mesure de température, et la comparaison entre les informations que l'organe de mesure de courant ou que l'organe de mesure de tension fournit et celles fournies par l'organe de mesure de température permet de déterminer si l'organe de mesure de température est opérationnel.

Le procédé peut comporter l'étape selon laquelle, selon que l'enroulement électrique de stator est effectivement parcouru par du courant homopolaire, on détermine si chaque phase de l'enroulement électrique de stator a la même résistance électrique.

Le circuit peut comporter un organe de mesure de tension, de courant ou de température ayant préalablement été étalonné et, lorsque cet organe de mesure donne une même information d'une phase électrique à l'autre, on en déduit que la résistance électrique est égale d'une phase électrique à l'autre.

En variante, deux organes de mesure préalablement étalonnés ou non peuvent être prévus, par exemple un organe de mesure de tension et un organe de mesure de courant, et lorsque ces deux organes de mesure donnent une même information d'une phase électrique à l'autre, on en déduit que la résistance électrique est égale d'une phase électrique à l'autre.

Le circuit électrique peut comporter une pluralité de modules de puissance regroupant des cellules de commutation du système de commutation. Chaque module de puissance peut présenter une liaison thermique avec un fluide de refroidissement et le procédé peut comporter l'étape selon laquelle, notamment une fois que l'on a déterminé que la résistance électrique est égale d'une phase électrique à l'autre et que l'on a déterminé que l'organe de mesure de température est opérationnel, on détermine à l'aide de l'organe de mesure de température si la liaison thermique de chaque module de puissance est opérationnelle. L'organe de mesure de température peut avoir été préalablement étalonné ou son caractère opérationnel peut avoir déjà été établi, par exemple par comparaison avec des mesures fournies par un ou plusieurs autres organes de mesure déjà étalonnés, comme mentionné ci-dessus.

Le fluide de refroidissement est par exemple de l'air, de l'eau liquide ou tout autre liquide.

La détermination du caractère opérationnel des liaisons thermiques peut être effectuée en comparant chaque mesure de température obtenue à une valeur de température attendue. En fonction du résultat de la comparaison, on décide ou non que la liaison thermique est opérationnelle. La valeur attendue peut être la même pour chaque liaison thermique.

En variante, on peut comparer les mesures de température entre elles et décider qu'une mesure de température non cohérente par rapport aux autres mesures de température obtenues correspond à une liaison thermique non opérationnelle.

On peut ainsi repérer les liaisons thermiques non satisfaisantes et les traiter avant que des températures trop importantes ne soient atteintes dans le circuit électrique.

Comme mentionné ci-dessus, la commande du système de commutation pour que ce dernier injecte du courant homopolaire dans l'enroulement électrique de stator peut permettre de vérifier tout ou partie des états suivants du circuit électrique :

- caractère opérationnel du système de commutation, notamment fonctionnement de ses cellules de commutation et/ou de son unité de contrôle,
- caractère opérationnel d'organes de mesure, par exemple d'organes de mesure de courant, de tension ou de température, notamment pour savoir s'ils fournissent une précision satisfaisante,
- comparaison entre les valeurs des résistances électriques des phases du stator.
- caractère opérationnel des liaisons thermiques entre les modules de puissance et le fluide de refroidissement correspondant, notamment pour savoir si ces modules sont convenablement refroidis.

Le circuit électrique peut être embarqué dans un véhicule électrique ou hybride, c'est-à-dire un véhicule dont la propulsion peut être effectuée exclusivement ou en partie seulement à l'aide de la machine électrique tournante, et la machine électrique tournante peut servir à propulser le véhicule.

Notamment dans ce cas, le procédé peut être mis en œuvre avant l'alimentation électrique de la machine électrique tournante pour assurer la propulsion du véhicule. Cette mise en œuvre du procédé permet de vérifier le ou les états ci-dessus et de remédier aux éventuels défauts avant que la machine électrique tournante ne soit sollicitée pour propulser le véhicule.

Le procédé peut ainsi être mis en œuvre préalablement au déplacement du véhicule sous l'effet de la propulsion totale ou partielle par la machine électrique.

Dans un exemple de mise en œuvre de l'invention, le système de commutation comprend une pluralité de bras montés en parallèle, chaque bras comprenant deux cellules de commutation commandables séparées par un point milieu, chaque phase électrique étant disposée entre les points milieux de deux bras dédiés à ladite phase.

Le circuit peut comporter une unité de stockage d'énergie électrique et un convertisseur de tension continu/continu interposé entre l'unité de stockage d'énergie électrique et le système de commutation. Lors de la mise en œuvre du procédé, cette unité de stockage d'énergie peut être la source d'énergie alimentant l'enroulement électrique de stator à travers le système de commutation.

L'unité de stockage d'énergie électrique peut être une batterie, un super-condensateur ou tout assemblage de batteries ou de super-condensateurs. Il s'agit par exemple de plusieurs branches en parallèle de batteries en série. L'unité de stockage d'énergie électrique peut avoir une tension nominale comprise entre 60 V et 400 V, notamment entre 200 V et 400 V.

Le circuit peut comprendre un connecteur apte à être branché à un connecteur de type complémentaire d'un réseau électrique pour charger l'unité de stockage d'énergie électrique, le connecteur comprenant au moins une pluralité de contacts ayant chacun une extrémité libre et une autre extrémité reliée à un point intermédiaire d'une phase électrique. Le réseau électrique alimente ainsi chaque phase via un point intermédiaire de celle-ci, notamment un point milieu de celle-ci.

Un tel circuit électrique peut être à la fois utilisé pour :

-   alimenter les phases électriques du stator depuis l'unité de stockage d'énergie électrique et à travers le système de commutation utilisé en onduleur pour faire tourner la machine électrique, et
-   charger l'unité de stockage d'énergie électrique à travers les phases électriques du stator utilisées comme inductances et à travers le système de commutation utilisé comme redresseur.

La structure du circuit et la commande des cellules de commutation du système de commutation peuvent permettre la charge de l'unité de stockage d'énergie électrique sans mise en mouvement du rotor.

Le réseau peut délivrer l'une quelconque d'une grandeur électrique d'alimentation alternative et d'une grandeur électrique d'alimentation continue. En particulier, la commande des cellules de commutation peut être effectuée comme décrit dans la demande déposée en France le 21 décembre 2011 sous le numéro 11 62140 par la Déposante.

Un tel circuit électrique peut ainsi être branché à tout type de réseau, à savoir aussi bien un réseau polyphasé ou monophasé délivrant une tension alternative qu'à un réseau délivrant une tension continue ou un courant continu.

La machine électrique tournante peut présenter une puissance nominale comprise entre 10W et 10 MW, notamment comprise entre 100W et 200kW.

La machine électrique tournante peut être une machine synchrone, notamment à aimants permanents. En variante, il peut s'agir d'une machine asynchrone ou d'une machine à reluctance variable. Il peut s'agir d'une machine à courant alternatif.

Le procédé ci-dessus selon l'invention peut permettre d'établir un diagnostic quant à l'un au moins des états mentionnés ci-dessus du circuit électrique.

L'invention pourra être mieux comprise à la lecture de la description qui va suivre d'un exemple non limitatif de mise en œuvre de celle-ci et à l'examen du dessin annexé sur lequel :

-   la figure 1 représente un circuit électrique au sein duquel le procédé selon un mode de réalisation de l'invention peut être mis en oeuvre,
-   la figure 2 représente de façon schématique un véhicule auquel le circuit électrique de la figure 1 peut être intégré,
-   la figure 3 illustre les tensions et les courants propres à chaque phase électrique de l'enroulement électrique de stator représenté sur les figures 1 et 2 lorsque ce dernier est parcouru par du courant homopolaire, et
-   la figure 4 représente de façon fonctionnelle et partielle dans le référentiel de Park un exemple d'unité de contrôle du système de commutation.

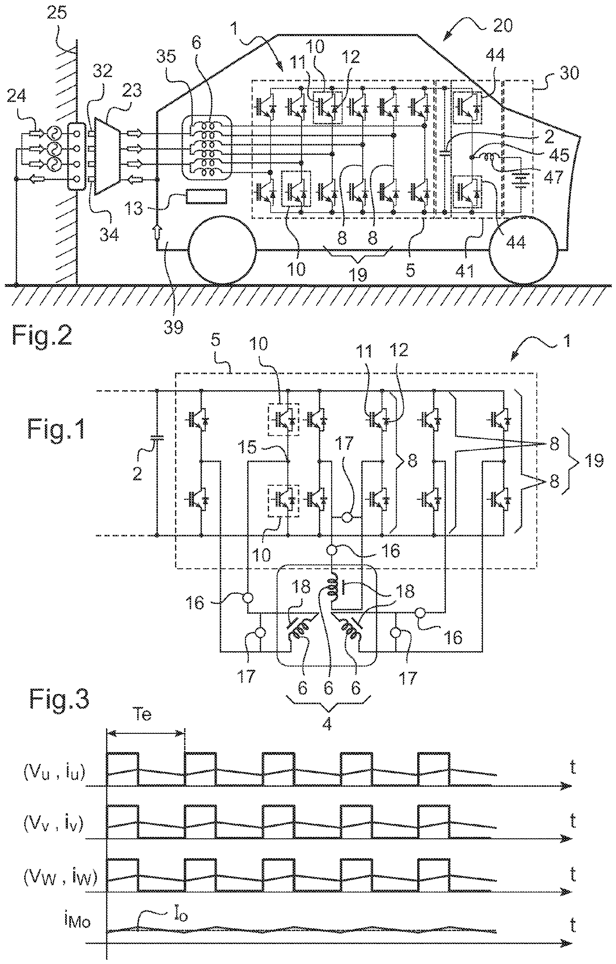

On a représenté sur la figure 1 un circuit électrique 1 dont un ou plusieurs états peuvent être déterminés.

Ce circuit 1 comprend un condensateur 2 qui présente par exemple une capacité comprise entre 100 $\mu$F et 5000 $\mu$F. Le circuit électrique 1 comprend un enroulement électrique de stator 4 et un système de commutation 5 interposé entre le condensateur 2 et l'enroulement électrique de stator 4.

Une source d'énergie électrique non représentée sur la figure 1 est disposée en amont du condensateur 2 et elle peut alimenter l'enroulement électrique de stator 4 à travers le système de commutation 5.

Dans l'exemple considéré, le stator est triphasé, étant par exemple un stator de moteur synchrone, notamment à rotor à aimants permanents. En variante, le stator peut comporter plus de trois phases.

Dans d'autres variantes, le stator peut être un stator de machine à réluctance variable ou de machine asynchrone.

Le stator peut faire partie d'une machine électrique tournante configurée pour que la force électromotrice induite dans chaque phase du stator soit sinusoïdale ou ne comprenne pas d'harmonique de rang 3 ou de rang multiple de 3 lorsque le stator est alimenté en courant homopolaire.

L'enroulement électrique de stator 4 est dans l'exemple considéré formé par trois phases 6, respectivement désignées phase électrique u, v et w du stator. Dans ce qui suit, $v_u$ et $i_u$ désignent respectivement la tension aux bornes de la phase u et le courant parcourant celle-ci, $v_v$ et $i_v$ désignent respectivement la tension aux bornes de la phase v et le courant parcourant celle-ci et $v_w$ et $i_w$ désignent respectivement la tension aux bornes de la phase w et le courant parcourant celle-ci.

La tension homopolaire est définie par $u_{M0} = (u_U + u_V + u_W)/3$ et le courant homopolaire est défini par

$i_{M0} = (i_U + i_V + i_W)/3.$

Dans l'exemple représenté, le système de commutation 5 comprend une pluralité de bras 8, chaque bras étant monté en parallèle du condensateur 2. Chaque bras 8 comprend dans cet exemple deux cellules de commutation 10 commandables. Chaque cellule de commutation 10 est par exemple formée par un interrupteur commandable 11 en anti-parallèle duquel est montée une diode 12. L'interrupteur 11 peut être un transistor, notamment un transistor à effet de champ, bipolaire ou de type IGBT.

Une unité de contrôle centralisée 13 comprenant des moyens de traitement numérique ou non peut piloter l'ensemble des transistors 11. L'unité de contrôle 13 comprend dans l'exemple considéré un ou plusieurs microcontrôleurs et/ou un ou plusieurs circuits logiques programmables.

Chaque bras 8 comprend un point milieu 15 entre les deux cellules de commutation 10 et chaque point milieu 15 d'un bras 8 est dans l'exemple décrit relié à une borne d'une des phases 6. Chaque phase électrique 6 peut ainsi être disposée entre deux points milieu 15 de deux bras distincts, ces deux bras 8 formant alors un pont en H 19. Chaque pont en H 19 peut être dédié à une phase spécifique 6 de l'enroulement électrique de stator 4.

Comme on peut le voir, les phases 6 ne sont pas couplées entre elles. En effet, dans l'exemple de la figure 1, chaque phase 6 a ses bornes directement reliées à des éléments autres, ici des cellules de commutation 10, que des autres phases 6, contrairement à ce qui serait le cas si l'enroulement électrique de stator 4 était connecté en étoile ou en triangle.

Comme représenté schématiquement sur la figure 1, des organes de mesure de grandeurs liées au passage de courant électrique dans l'enroulement électrique de stator 4 sont prévus. Dans l'exemple considéré, un organe 16 de mesure du courant dans chaque phase 6, un organe 17 de mesure de la tension aux bornes de chaque phase 6 et un organe 18 de mesure de la température dans chaque phase sont prévus.

L'organe 16 de mesure du courant dans chaque phase comprend par exemple un ampèremètre monté en série avec chaque phase 6 tandis que l'organe 17 de mesure de la tension aux bornes de chaque phase comprend un voltmètre monté en parallèle de chaque phase 6 et tandis que l'organe 18 de mesure de température comprend un capteur de température associé à chaque phase 6, ce capteur de température étant par exemple disposé à un point chaud du bobinage, par exemple dans un des chignons de tête de bobines.

L'invention n'est pas limitée à la présence simultanée des exemples d'organes de mesure 16, 17 et 18 ci-dessous. Dans des variantes non illustrées, un nombre différent d'organes de mesure peut être utilisé et la nature de ces organes de mesure peut être différente.

Le circuit électrique 1 décrit en référence à la figure 1 peut être intégré au système de charge et de traction d'un véhicule 20 qui est par exemple une automobile à propulsion hybride ou exclusivement électrique.

Le circuit 1 peut alors, comme représenté sur la figure 2, comprendre :

- un connecteur 23 destiné à être branché à un réseau électrique 24 via un connecteur d'un moyen de charge en énergie électrique 25, et
- une unité de stockage d'énergie électrique 30. L'unité de stockage d'énergie électrique 30 peut être une batterie ou une association en parallèle et/ou en série de batteries.

Le réseau électrique 24 est dans cet exemple un réseau triphasé mais l'invention s'applique à des réseaux polyphasés autres que triphasés ou à des réseaux monophasés. Il s'agit par exemple d'un réseau industriel géré par un opérateur et déployé à une échelle régionale, nationale ou internationale. Le réseau délivre par exemple une tension de fréquence égale à 50 Hz ou 60 Hz.

Dans l'exemple de la figure 2, le connecteur 23 comprend quatre contacts. Trois contacts principaux 32 présentent chacun une extrémité libre destinée à être branchée au contact de type complémentaire du connecteur du moyen de charge 25. Le quatrième contact 34 du connecteur 23 est relié à la carrosserie 39 du véhicule 1 et destiné à être branché à la terre du réseau électrique 24.

Comme on peut le voir, chaque contact principal 32 peut avoir une autre extrémité reliée à une phase électrique 6. Dans l'exemple de la figure 2, cette extrémité est reliée à un point milieu 35 d'une phase électrique 6, c'est-à-dire que la liaison avec le contact 32 sépare la phase électrique 6 en un nombre exactement égal de spires lorsque la phase est formée par une seule bobine. Dans une variante, chaque phase peut comprendre deux bobines identiques montées en série et la liaison avec le contact 32 peut être ménagée entre ces deux bobines.

Chacune des phases 6 est ainsi partagée en deux demi-phases parcourues par des courants opposés d'une demi-phase à l'autre lorsque du courant va du réseau électrique 24 vers l'unité de stockage d'énergie électrique 30 via le système de commutation 5 et les phases 6.

Le circuit 1 comprend encore dans l'exemple considéré un convertisseur de tension continu/continu 41. Le condensateur 2 est interposé entre le système de commutation 5 et le convertisseur de tension continu/continu 41 dont il forme une entrée. L'unité de stockage d'énergie électrique 30 est montée en sortie du convertisseur 41.

Le convertisseur 41 est dans l'exemple représenté un hacheur série délivrant à l'unité de stockage d'énergie électrique 30 une tension de sortie obtenue par dévoltage de la tension d'entrée aux bornes de chaque bras 8. De façon connue, ce hacheur série 41 comprend deux cellules de commutation 44, identiques ou non aux cellules de commutation 10 du système de commutation 5 et séparées par un point médian 45. Les cellules 44 peuvent être pilotées par l'unité de commande 13. Chacune de ces cellules 44 est dans l'exemple considéré réversible, comprenant en antiparallèle un interrupteur commandable et une diode. Une inductance 47 est interposée entre ce point médian 45 et l'unité de stockage d'énergie électrique 30.

L'unité de commande 13 peut être configurée pour commander les interrupteurs des cellules de commutation 10 et 44 ci-dessus en ouverture et en fermeture de manière à ce que :

- l'unité de stockage d'énergie électrique 30 soit chargée par le réseau électrique 24 auquel est branché le connecteur 23 selon un mode de fonctionnement, et
- l'unité de stockage d'énergie électrique 30 alimente les phases électriques 6 de l'enroulement électrique de stator 4 de manière à générer un couple moteur entraînant le véhicule 20 selon un autre mode de fonctionnement.

En particulier, le connecteur 23 et la commande des cellules de commutations 10 et/ou 44 peuvent être tels qu'exposé dans la demande déposée en France le 21 décembre 2011 sous le numéro 11 62140 par la Déposante et dont le contenu est incorporé à la présente demande par référence, pour permettre la charge de l'unité de stockage d'énergie électrique 30 depuis tout type de réseau électrique 24.

L'unité de contrôle 13 est en outre configurée dans l'exemple décrit pour commander le système de commutation 5 de manière à transformer un courant d'alimentation provenant de l'unité de stockage d'énergie électrique 30 en courant homopolaire.

La commande appliquée au système de commutation 5 vise à ce que le courant électrique parcourant chaque phase électrique 6 soit égal au même instant et à ce que la tension aux bornes de chacune de ces phases électriques 6 soit égale, comme représenté sur la figure 3.

Comme on peut également le voir sur cette figure 3, la commande vise à réguler le courant homopolaire autour d'une valeur non nulle prédéfinie $I_0$.

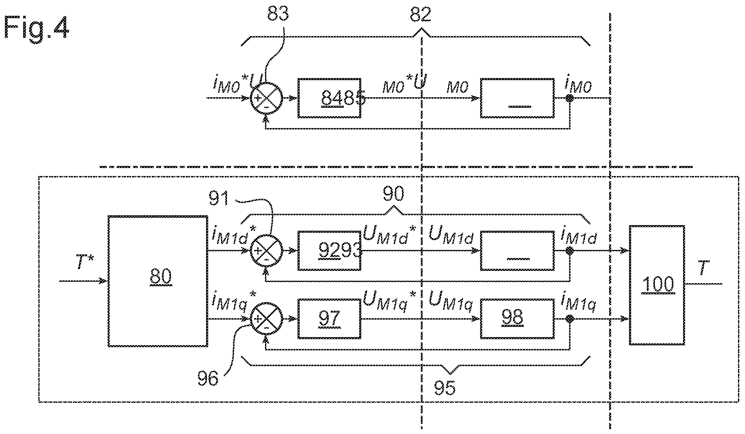

Un exemple de mise en œuvre de cette commande dans le référentiel de Park est représenté sur la figure 4.

L'unité de contrôle 13 comprend un système 82 qui est configuré pour effectuer une régulation en boucle fermée du courant homopolaire $i_{M0}$. Ce système 82 comprend un bloc 84 configuré pour générer une tension homopolaire consigne $u_{M0}^*$ à partir d'une comparaison effectuée par un sommateur 83 entre un courant homopolaire consigne $i_{M0}^*$ que l'on cherche à appliquer, et le courant homopolaire $i_{M0}$ correspondant à la composante homopolaire des courants circulant dans les phases 6 de l'enroulement électrique de stator 4.

Le système 82 comprend également un bloc 85 configuré pour générer un courant homopolaire $i_{M0}$ à partir de la tension homopolaire obtenue.

L'unité de contrôle 13 comprend par ailleurs :

- un bloc 80 configuré pour générer un courant principal de consigne $i_{M1}^*$ à partir du couple principal de consigne à appliquer à la machine, ce couple étant nul dans l'exemple considéré, ce courant principal se décomposant, selon le formalisme de Park de "la machine dq", en deux composantes $i_{M1d}^*$ et $i_{M1q}^*$,

- un système 90 configuré pour réguler en boucle fermée la composante directe $i_{M1d}$ du courant principal, ce courant étant nul pour la mise en œuvre de l'invention, et
- un système 95 configuré pour réguler en boucle fermée la composante en quadrature $i_{M1q}$ du courant principal, ce courant étant nul pour la mise en œuvre de l'invention,

Le système de régulation 90 comprend un bloc 92 générant une composante $u_{M1d}^*$ de tension principale de consigne à partir d'une comparaison effectuée par un sommateur 91 entre la composante $i_{M1d}^*$ du courant principal de consigne et la composante $i_{M1d}$ du courant principal circulant dans les phases 6 de l'enroulement électrique de stator 4. Un bloc 93 configuré pour générer une composante $i_{M1d}$ du courant principal à partir de la composante $u_{M1d}^*$ de la tension principale obtenue est également représenté.

Le système de régulation 95 comprend un bloc 97 de génération d'une composante $u_{M1q}^*$ de tension principale de consigne à partir d'une comparaison effectuée par un sommateur 96 entre la composante $i_{M1q}^*$ du courant principal et la composante $i_{M1q}$ du courant principal circulant dans les phases 6 de l'enroulement électrique de stator 4. Un bloc 98 de génération d'une composante $i_{M1q}$ du courant principal à partir de la composante $u_{M1q}^*$ de tension principale est également représenté.

Le bloc 100 est configuré pour convertir les

composantes $i_{M1d}$ et $i_{M1q}$ du courant principal en un couple principal $T$.

Les blocs 85, 93 et 98 correspondent à l'alimentation par la sortie du système de commutation 5 de l'enroulement électrique de stator 4 des phases u, v et w du stator avec des tensions de valeur $u_{M0}$, $u_{M1d}$, $u_{M1q}$ provenant des consignes de tension grâce à la commande appropriée des interrupteurs électroniques 11 des cellules de commutation 10.. Le courant peut être mesuré dans chaque phase 6 par l'organe 16 de mesure de courant et l'unité de contrôle 13 peut déduire de ces mesures le courant homopolaire $i_{M0}$ et/ou les composantes $i_{M1d}$, $i_{M1q}$ du courant principal avec lesquels les comparaisons sont effectuées par les sommateurs 83, 91 et 96.

Lors de la mise en œuvre du procédé selon l'invention, on demande à l'unité de contrôle 13 de commander les interrupteurs électroniques 11 des cellules de commutation 10 de manière à ce que l'enroulement électrique de stator 4 soit parcouru par du courant homopolaire.

Le procédé consiste à déterminer si l'enroulement électrique de stator 4 est effectivement parcouru par du courant homopolaire et à en déduire un ou plusieurs état du circuit électrique 1.

On va décrire ci-après quelques exemples d'états du circuit électrique 1 pouvant être déterminés selon le procédé ci-dessus.

Lorsque l'unité de contrôle 13 est commandée pour appliquer du courant homopolaire à l'enroulement électrique de stator 4, l'un des organes de mesure 16, 17 ou 18 ayant été préalablement étalonné peut être activé et les informations fournies par cet organe de mesure 16, 17 ou 18 peuvent être lues.

Lorsqu'il s'agit de l'organe de mesure de courant 16, la confirmation par ce dernier que chaque phase 6 est parcourue par un courant électrique non nul et égal confirme que le système de commutation 5 alimente véritablement l'enroulement électrique de stator 4 en courant homopolaire.

En variante, aucun des organes de mesure 16, 17 ou 18 n'a préalablement été étalonné mais la concordance des informations fournies par ces deux ou trois organes de mesure permet de déduire que l'enroulement électrique de stator 4 est bien alimenté en courant homopolaire.

On vérifie alors que les cellules de commutation 10 sont bien opérationnelles et que l'unité de contrôle 13 fonctionne correctement. Ainsi, on peut s'assurer que la commande représentée sur la figure 4 est correctement programmée et que le ou les systèmes de traitement en charge de l'exécution de cette commande, à savoir un ou plusieurs microcontrôleurs et un ou plusieurs FPGA fonctionnent.

En variante ou en combinaison de la détermination d'état(s) du système de commutation 5, le procédé peut permettre de s'assurer que l'enroulement électrique de stator 4 a des résistances égales d'une phase 6 à l'autre.

Pour ce faire, on peut lire les informations fournies pour chaque phase 6 par l'organe de mesure de courant 16 et par l'organe de mesure de tension 17 et l'on peut calculer la valeur de la résistance de chacune des phases 6.

En variante ou en combinaison des états ci-dessus du circuit 2, d'autres états peuvent être déterminés.

L'un des organes de mesure 16, 17 ou 18 a par exemple été préalablement étalonné et on lit les informations fournies par cet organe de mesure étalonné lorsque du courant homopolaire parcourt l'enroulement électrique de stator 4.

Lorsque cet organe de mesure étalonné indique que l'enroulement électrique de stator 4 est effectivement parcouru par du courant homopolaire, on lit les informations fournies par l'un et/ou l'autre des autres organes de mesure pour chaque phase électrique.

Pour chacun des organes de mesure non étalonnés, si la mesure fournie pour chaque phase confirme que l'enroulement électrique de stator 4 est parcouru par du courant homopolaire, on en déduit que cet organe de mesure est opérationnel.

Dans une variante, aucun des organes de mesure n'a été préalablement étalonné et on compare les valeurs fournies par chaque organe de mesure d'une phase 6 à l'autre. Lorsque chaque organe de mesure indique que du courant homopolaire parcourt l'enroulement électrique de stator 4, on en déduit que ces organes de mesure sont opérationnels.

Le circuit électrique 1 peut comprendre des modules de puissance, les cellules de commutation 10 d'un même bras 8 appartenant par exemple à un même module de puissance. Chaque module de puissance peut présenter une liaison thermique avec un fluide de refroidissement, par exemple de l'air ou de l'eau liquide. Lorsque l'on a déterminé que la résistance électrique est sensiblement égale d'une phase électrique 6 à l'autre et/ou que l'on sait ou que l'on a déterminé que l'organe de mesure de température 18 est opérationnel, en mesurant la valeur de température donnée pour chaque phase électrique 6 et en les comparant avec une valeur attendue, ou même par une simple comparaison entre ces valeurs mesurées, on peut déterminer si la liaison thermique de chaque module de puissance est opérationnelle.

L'invention n'est pas limitée aux exemples qui viennent d'être décrits, n'étant limitée que par les revendications.

L'expression « comportant un » doit être comprise comme signifiant « comportant au moins un », sauf lorsque le contraire est spécifié.

**Revendications**

1. Procédé de détermination d'au moins un état d'un circuit électrique (1), le circuit électrique (1) comportant au moins :

- un enroulement électrique de stator (4) de machine électrique tournante polyphasée, ledit enroulement (4) comprenant une pluralité de phases électriques (6), lesdites phases électriques (6) n'étant pas électriquement couplées entre elles, et
- un système de commutation (5) à travers lequel l'enroulement électrique de stator (4) est alimenté par une source d'énergie électrique,

procédé dans lequel :

- on commande le système de commutation (5) de manière à ce que l'enroulement électrique de stator (4) soit parcouru par le courant homopolaire, et
- selon que l'enroulement électrique de stator (4) est effectivement ou non parcouru par le courant homopolaire, on détermine ledit état du circuit électrique (1).

2. Procédé selon la revendication 1, dans lequel le circuit électrique (1) comprend au moins un organe de mesure (16, 17) de grandeur électrique liée au passage de courant électrique dans l'enroulement électrique de stator (4), ladite grandeur permettant de déterminer si l'enroulement électrique de stator (4) est effectivement ou non parcouru par du courant homopolaire.

3. Procédé selon la revendication 2, dans lequel lorsque l'on obtient la même valeur pour ladite grandeur électrique d'une phase électrique (6) à l'autre, on en déduit que l'enroulement électrique de stator (4) est effectivement parcouru par du courant homopolaire et que le système de commutation (5) est opérationnel.

4. Procédé selon l'une quelconque des revendications précédentes, dans lequel le circuit électrique (1) comprend un organe (17) de mesure de température associé à l'enroulement électrique de stator (4).

5. Procédé selon la revendication 4, dans lequel lorsque l'on obtient la même valeur pour la température d'une phase électrique (6) à l'autre, on en déduit que l'enroulement électrique de stator (4) est effectivement parcouru par du courant homopolaire et que le système de commutation (5) est opérationnel.

6. Procédé selon la revendication 3 ou 5, dans lequel le système de commutation (5) comprend une pluralité de cellules de commutation (10) et dans lequel on détermine que les cellules de commutation (10) sont opérationnelles.

7. Procédé selon la revendication 6 et la revendication 4, dans lequel le circuit électrique (1) comporte une pluralité de modules de puissance regroupant des cellules de commutation (10), chaque module de puissance présentant une liaison thermique avec un fluide de refroidissement et le procédé comportant l'étape selon laquelle on détermine à l'aide de l'organe (18) de mesure de température si la liaison thermique de chaque module de puissance est opérationnelle.

8. Procédé selon l'une quelconque des revendications 3 ou 5 à 7, dans lequel le système de commutation (5) comprend une unité de contrôle (13) et dans lequel on détermine que l'unité de contrôle (13) est opérationnelle.

9. Procédé selon l'une quelconque des revendications précédentes, dans lequel le circuit électrique (1) comprend au moins deux organes (16, 17, 18) de mesure d'une grandeur liée au passage du courant électrique dans l'enroulement électrique de stator (4), et dans lequel l'un de ces organes (16, 17, 18) de mesure a été préalablement étalonné.

10. Procédé selon la revendication 9, dans lequel, lorsque les informations fournies par l'organe de mesure préalablement étalonné (16, 17, 18) confirment que l'enroulement électrique de stator (4) est parcouru par du courant homopolaire et que les informations fournies par le ou les autres organes de mesure (16, 17, 18) indiquent également que l'enroulement électrique de stator (4) est parcouru par du courant homopolaire, on en déduit que ce ou ces autres organes de mesure (16, 17, 18) sont opérationnels.

11. Procédé selon l'une quelconque des revendications précédentes, dans lequel, selon que l'enroulement électrique de stator (4) est effectivement parcouru par du courant homopolaire, on détermine si chaque phase électrique (6) a la même résistance électrique.

12. Procédé selon l'une quelconque des revendications précédentes, le circuit électrique (1) étant embarqué dans un véhicule électrique ou hybride (1) et la machine électrique tournante servant à propulser le véhicule.

13. Procédé selon la revendication 12, étant mis en œuvre avant l'alimentation électrique de la machine électrique tournante pour assurer la propulsion du véhicule (1).

**Patentansprüche**

1. Verfahren zur Bestimmung wenigstens eines Zustandes einer elektrischen Schaltung (1), wobei die elektrische Schaltung (1) wenigstens umfasst:

- eine elektrische Statorwicklung (4) einer mehrphasigen drehenden elektrischen Maschine, wobei die Wicklung (4) eine Vielzahl elektrischer Phasen (6) umfasst, wobei die elektrischen Phasen (6) nicht untereinander elektrisch verbunden sind, und
- ein Schaltsystem (5), über das die elektrische Statorwicklung (4) durch eine elektrische Energiequelle versorgt wird,

ein Verfahren, wobei

- das Schaltsystem (5) so gesteuert wird, dass die elektrische Statorwicklung (4) vom homopolaren Strom durchflossen wird, und
- danach, ob die elektrische Statorwicklung (4) effektiv vom homopolaren Strom durchflossen wird oder nicht, der Zustand der elektrischen Schaltung (1) bestimmt wird.

2. Verfahren nach Anspruch 1, wobei die elektrische Schaltung (1) mindestens ein Messorgan (16, 17) einer elektrischen Größe umfasst, die mit dem Durchfluss des elektrischen Stroms in der elektrischen Statorwicklung (4) in Bezug steht, wobei die Größe es ermöglicht, zu bestimmen, ob die elektrische Statorwicklung (4) effektiv von homopolarem Strom durchflossen wird oder nicht.

3. Verfahren nach Anspruch 2, wobei bei Erhalten desselben Wertes für die elektrische Größe von einer elektrischen Phase (6) zur anderen daraus abgeleitet wird, dass die elektrische Statorwicklung (4) effektiv von homopolarem Strom durchflossen wird und dass das Schaltsystem (5) funktionsfähig ist.

4. Verfahren nach einem der vorhergehenden Ansprüche, wobei die elektrische Schaltung (1) ein Temperaturmessorgan (17) umfasst, das mit der elektrischen Statorwicklung (4) verknüpft ist.

5. Verfahren nach Anspruch 4, wobei bei Erhalten desselben Wertes für die Temperatur von einer elektrischen Phase (6) zur anderen daraus abgeleitet wird, dass die elektrische Statorwicklung (4) effektiv von homopolarem Strom durchflossen wird und dass das Schaltsystem (5) funktionsfähig ist.

6. Verfahren nach Anspruch 3 oder 5, wobei das Schaltsystem (5) eine Vielzahl von Schaltzellen (10) umfasst und wobei bestimmt wird, dass die Schaltzellen (10) funktionsfähig sind.

7. Verfahren nach Anspruch 6 und Anspruch 4, wobei die elektrische Schaltung (1) eine Vielzahl von Leistungsmodulen umfasst, die Schaltzellen (10) zusammenfassen, wobei jedes Leistungsmodul eine thermische Verbindung mit einem Kühlfluid aufweist und das Verfahren den Schritt umfasst, wobei mithilfe des Temperaturmessorgans (18) bestimmt wird, ob die thermische Verbindung jedes Leistungsmoduls funktionsfähig ist.

8. Verfahren nach einem der Ansprüche 3 oder 5 bis 7, wobei das Schaltsystem (5) eine Steuereinheit (13) umfasst und wobei bestimmt wird, dass die Steuereinheit (13) funktionsfähig ist.

9. Verfahren nach einem der vorhergehenden Ansprüche, wobei die elektrische Schaltung (1) mindestens zwei Messorgane (16, 17, 18) einer Größe umfasst, die mit dem Durchfluss des elektrischen Stroms in der elektrischen Statorwicklung (4) in Bezug stehen und wobei eines dieser Messorgane (16, 17, 18) zuvor kalibriert wurde.

10. Verfahren nach Anspruch 9, wobei, wenn die vom zuvor kalibrierten Messorgan (16, 17, 18) gelieferten Informationen bestätigen, dass die elektrische Statorwicklung (4) von homopolarem Strom durchflossen wird, und die von dem oder den anderen Messorganen (16, 17, 18) gelieferten Informationen ebenfalls angeben, dass die elektrische Statorwicklung (4) von homopolarem Strom durchflossen wird, daraus abgeleitet wird, dass das oder die anderen Messorgane (16, 17, 18) funktionsfähig sind.

11. Verfahren nach einem der vorhergehenden Ansprüche, wobei danach, ob die elektrische Statorwicklung (4) effektiv von homopolarem Strom durchflossen wird, bestimmt wird, ob jede elektrische Phase (6) denselben elektrischen Widerstand aufweist.

12. Verfahren nach einem der vorhergehenden Ansprüche, wobei sich die elektrische Schaltung (1) an Bord eines Elektro- oder Hybridfahrzeugs (1) befindet und die drehende elektrische Maschine dazu dient, das Fahrzeug anzutreiben.

13. Verfahren nach Anspruch 12, das vor der elektrischen Versorgung der drehenden elektrischen Maschine umgesetzt wird, um den Antrieb des Fahrzeugs (1) zu gewährleisten.

**Claims**

1. Method for determining at least one state of an electrical circuit (1), the electrical circuit (1) comprising at least:

- one electrical stator winding (4) of a polyphase rotating electrical machine, said winding (4) comprising a plurality of electrical phases (6), said electrical phases (6) not being electrically coupled together, and

- one switching system (5) through which the electrical stator winding (4) is powered by a source of electrical energy,

method in which:

- the switching system (5) is controlled in such a way that the electrical stator winding (4) is passed through by the zero-sequence current, and
- depending on whether the electrical stator winding (4) is actually passed through or not by the zero-sequence current, said state of the electrical circuit (1) is determined.

2. Method according to Claim 1, in which the electrical circuit (1) comprises at least one measurement member (16, 17) for measuring an electrical quantity linked to the flow of electrical current in the electrical stator winding (4), said quantity making it possible to determine whether the electrical stator winding (4) is actually passed through or not by zero-sequence current.

3. Method according to Claim 2, in which, when the same value is obtained for said electrical quantity from one electrical phase (6) to the other, it is deduced therefrom that the electrical stator winding (4) is actually passed through by zero-sequence current and that the switching system (5) is operational.

4. Method according to any one of the preceding claims, in which the electrical circuit (1) comprises a temperature measurement member (17) associated with the electrical stator winding (4).

5. Method according to Claim 4, in which, when the same value is obtained for the temperature from one electrical phase (6) to the other, it is deduced therefrom that the electrical stator winding (4) is actually passed through by zero-sequence current and that the switching system (5) is operational.

6. Method according to Claim 3 or 5, in which the switching system (5) comprises a plurality of switching cells (10) and in which it is determined that the switching cells (10) are operational.

7. Method according to Claim 6 and Claim 4, in which the electrical circuit (1) comprises a plurality of power modules grouping together switching cells (10), each power module exhibiting a thermal link with a coolant and the method comprising the step according to which the temperature measurement member (18) is used to determine whether the thermal link of each power module is operational.

8. Method according to any one of Claims 3 or 5 to 7, in which the switching system (5) comprises a control unit (13) and in which it is determined that the control unit (13) is operational.

9. Method according to any one of the preceding claims, in which the electrical circuit (1) comprises at least two members (16, 17, 18) for measuring a quantity linked to the flow of the electrical current in the electrical stator winding (4), and in which one of these measurement members (16, 17, 18) has previously been calibrated.

10. Method according to Claim 9, in which, when the information supplied by the previously calibrated measurement member (16, 17, 18) confirms that the electrical stator winding (4) is passed through by zero-sequence current and that the information supplied by the other measurement member or members (16, 17, 18) also indicates that the electrical stator winding (4) is passed through by zero-sequence current, it is deduced therefrom that this or these other measurement member or members (16, 17, 18) is or are operational.

11. Method according to any one of the preceding claims, in which, depending on whether the electrical stator winding (4) is actually passed through by zero-sequence current, a determination is made as to whether each electrical phase (6) has the same electrical resistance.

12. Method according to any one of the preceding claims, the electrical circuit (1) being installed in an electric or hybrid vehicle (1) and the rotating electrical machine being used to propel the vehicle.

13. Method according to Claim 12, being implemented before the rotating electrical machine is electrically powered to ensure the propulsion of the vehicle (1).

Fig.2

Fig.1

Fig.3

Fig.4

**EP 2 850 442 B1**

## RÉFÉRENCES CITÉES DANS LA DESCRIPTION

**Documents brevets cités dans la description**

- US 5568034 A